# EUROPÄISCHE PATENTSCHRIFT

(11) **EP 1 316 981 B1**
(45) Veröffentlichungstag und Bekanntmachung des Hinweises auf die Patenterteilung: **29.08.2007**
(21) Anmeldenummer: 02026208.5
(22) Anmeldetag: 26.11.2002
(51) Int. Cl.: H01H 35/14

(54) **Multi-Kugelschalter-Anordnung in Schicht-/Plattenbauweise**
Vibration sensor made from laminated substrates with conductive ball
Capteur de vibration stratifié avec bille électroconductrice

(30) Priorität: 29.11.2001 DE 10158416
(43) Veröffentlichungstag der Anmeldung: 04.06.2003
(73) Patentinhaber: Forschungszentrum Karlsruhe GmbH, 76133 Karlsruhe (DE); Robert Bodenstedt Elektronik, 86567 Hilgertshausen (DE)
(72) Erfinder: Blank, Thomas, 76187 Karlsruhe (DE); Berger, Lutz, 76344 Eggenstein-Leopoldshafen (DE); Bodenstedt, Robert, 86567 Hilgertshausen (DE)

(56) Entgegenhaltungen:
- US-A- 5 410 113
- US-A- 5 563 572
- US-A- 5 987 988

## Beschreibung

Die Erfindung betrifft eine Multi-Kugelschalter-Anordnung in Schicht-/Plattenbauweise.

Kugelschalter sind bereits seit 1976 beschrieben und patentiert. Sie dienen vornehmlich dem Zweck, einfache Bewegungen zu erfassen. Es gibt sie in unterschiedlichen Varianten, wobei den Schaltern gemeinsam ist, dass eine leitfähige Kugel oder ein Quecksilbertropfen mindestens zwei Kontaktflächen überbrückt und somit einen elektrischen Kontakt zwischen den beiden Kontaktflächen schließt (siehe z.B. US 3,927,286 und US 4,434,337 (Quecksilberschalter)).

Ein einzelner Kugelschalter besteht vom Prinzip her aus mindestens zwei elektrisch leitenden Flächen, die nicht unmittelbar miteinander in Kontakt stehen, aber Teil der Innenwand eines Volumens sind, in dem eine Kugel aus elektrisch leitendem Material beweglich ist und die beiden Flächen gleichzeitig berühren kann. Der Aufbau des Kugelschalters besteht im allgemeinen aus einem Becher, in dem die Kugel aufgenommen wird, eine Bodenplatte bzw. Kappe, mit dem der Becher verschlossen wird, und zwei Anschlussstiften, welche die elektrischen Kontakte formen.

Wie ein Kugelschalter, der als Beschleunigungssensor verwendet wird, aufgebaut ist, kann aus der US 5,987,988 entnommen werden. Der darin beschriebene Beschleunigungssensor besteht aus einem ersten, zweiten und dritten Substrat. Das zweite, mittlere Substrat hat ein Durchgangsloch, einen ersten Kontakt, der auf der Lochoberfläche besteht, und eine davon abgehende Kontaktfahne. Eine elektrisch leitfähige Kontaktkugel ist im Innern des Lochs beweglich eingeschlossen. Das dritte Substrat hat eine Vertiefung. Ein zweiter Kontakt befindet sich an der Vertiefung und kontaktiert das Untere der Kugel. Eine zweite Kontaktfahne ist mit dem zweiten Kontakt verbunden.

Der Aufbau eines Kugelschalters sowie der elektrische Test sind bisher aufwendig, weil die Schalter nur einzeln aufgebaut werden. Es sind mehrere Schritte notwendig, um den Schalter aufzubauen. Die Schalter müssen entweder einzeln getestet werden oder zu einer Matrix zusammengestellt werden, in der sie dann gleichzeitig getestet werden können.

Der Erfindung liegt die Aufgabe zugrunde, viele Kugelschalter einfach herzustellen und sie auch in ihrer Vielheit einfach auf Funktion testen zu können.

Die Aufgabe wird durch einen Aufbau eines Kugelschalters und die Anordnung vieler solcher gemäß den Merkmalen des Anspruchs 1 gelöst.

Die Multi-Kugelschalter-Anordnung 17 besteht aus geradlinig aneinandergereihten Reihen von Kugelschaltern 16, die pro Reihe hinsichtlich der Kontaktfahnen 3, 13 gleichartig ausgerichtet sind. Die erste, zweite und dritte Platte 1, 4, 5 der Kugelschalter 16 setzen sich bzw. ergänzen sich jeweils zu einer großen Platte, den beiden Außenplatten als Boden- 6 und Deckplatte 8 und der mittleren Platte 7 als Lochplatte. Keine der Kontaktfahnen 13 der Lochplatte 7 hat einen unmittelbaren elektrischen Kontakt zu einer der Kontaktfahnen 3 der Boden- 6 und Deckplatte 8.

Hinsichtlich ihrer Kontaktfahnen 3, 13 sind die Reihen aus Kugelschaltern 16 einheitlich ausgerichtet oder zwei unmittelbar benachbarte Reihen von Kugelschaltern 16 sind hinsichtlich ihrer Kontaktfahnen 3, 13 spiegelbildlich zueinander angeordnet.

Die Boden- 6 und Deckplatte 8 und die Lochplatte 7 sind aus handelsüblichen, mit den notwendigen elektrischen Leiterstrukturen versehenen Leiterplatten.

Eine zusätzliche Möglichkeit ist, dass die dritte große Platte 8, die Deckplatte 8, eine zur ersten großen Platte 6 spiegelsymmetrische Anordnung von Ringscheiben 2 aus elektrisch leitendem Material hat, von jeder dieser Ringscheiben 2 mindestens eine Kontaktfahne 3 nach außen zu mindestens einer zum Kugelschalter 16 gehörenden Rechteckseite geht und keine der Kontaktfahnen 3 der dritten großen Platte 8 einen unmittelbaren elektrischen Kontakt zu einer der zweiten 7 und/oder dritten großen Platte 6 hat. Damit kann die Multi-Kugelschalter-Anordnung 17 beliebig gedreht und geschwenkt werden. Jedes Loch und damit die eingeschlossene Kugel ist so von der Umgebung abgeschottet. Dadurch wird Verschmutzung der Löcher vermieden. Durch eine spezielle Atmosphäre in den Löchern, einem Schutzgas beispielsweise, kann eine höhere elektrische Isolationsschwelle und Abbrand verhindert werden.

Die Multi-Kugelschalter-Anordnung 17 einfacher Herstellung und mit hoher Schalterdichte lässt sich aus handelsüblichen, mit den notwendigen elektrischen Leiterstrukturen versehene Leiterplatten herstellen. Hier lässt sich vorteilhaft die Surface Mounted Device (SMD)-Technik einsetzen.

Die Multi-Kugelschalter-Anordnug 17 lässt sich leicht durch zwei oder drei mit elektrisch leitenden Flächen versehenen Platten herstellen. Zunächst werden die erste Außenplatte 6 und die Lochplatte 7 miteinander passgenau verbunden. Dann werden die Kugeln 14 auf der Seite mit den Löchern geschüttet und beispielsweise mit einem Lineal über die Öffnungen verstrichen, bis alle Löcher eine Kugel haben. Danach wird die kugelbefüllte Anordnung mit der zweiten,Außenplatte 8 verschlossen, die mindestens Verschlussfunktion hat aber auch noch eine elektrische Funktion durch einen Ringkontakt 2 beispielsweise zusätzlich haben kann. Durch Löten beispielsweise können die herausgeführten Kontaktfahnen 3 oder 13 einer Platte zu Gruppen elektrisch verbunden sein, so dass die Schalterfunktion jeden Kugelschalters rasch und automatisch getestet werden kann, beispielsweise durch Federkontaktstifte in entsprechender Matrixform. Bei rechteckigen Schaltergebieten können anschließend durch Trennen, beispielsweise Sägen, einzelne Kugelschalter 14 bereitgestellt werden. Insbesondere bei der Herstellung aus vorgefertigten Leiterplatinen ist eine Kontaktfahnenführung leicht und zweckmäßig einzurichten. Der Aufbau einer derartigen Multi-Kugelschalteranordnung 17 erlaubt den gleichzeitigen Test zumindest einer Reihe Kugelschalter und bedeutet dadurch ein hohes finanzielles und zeitliches Einsparungspotential bei der Fertigung.

Im Folgenden wird eine Ausführung anhand der Zeichnung näher erläutert. Die Zeichnung besteht aus 10 Figuren. Es zeigen:
Figur 1 den Schnitt durch einen Kugelschalter,
Figur 2 die Bodenkontaktfläche der Außenplatte,
Figur 3 die Umkontaktierungsebene in der Außenplatte,
Figur 4 die vollständige Außenplatte mit leitender Ringfläche,
Figur 5 der bewegliche Kontakt auf der Ringfläche,
Figur 6 die zweite Platte mit zylindrischer Innenfläche,
Figur 7 die Kugel im Becher,
Figur 8 der abgedeckte Becher,
Figur 9 viele Kugelschalter mit jeweils einer Durchkontaktierung für zwei Kugelschalter,
Figur 10 Vibrationsschalter im Leiterplattenverbund.

Die im Folgenden beschriebene beispielsweise Ausführung ist aus Leiterplatten, wie in der SMD-Technik üblich, hergestellt: Die eine Kontaktfläche wird durch die innere zylindrische Mantelwand 11, die andere durch die kreisförmige oder alternativ polygonale Ringfläche 2, in der Fachsprache auch Sackloch-PAD genannt, an einem Ende oder beiden Enden des Kontaktzylinders ausgeführt, wobei das PAD auf einer der beiden Außenplatten 1, 5 bzw. 6, 8 liegt. Die beiden Kontaktflächen 2, 11 sind elektrisch voneinander getrennt, können aber durch die Kugel 14 überbrückt werden. Der elektrische Anschluss der inneren Mantelwand 11 und der der Ringfläche 2 liegen einander auf der Außenplatte 1 bzw. 6 seitlich gegenüber.

### Erste Variante:

Auf der anderen Seite der Kugelschalteraußenplatte 1 wird der elektrische Anschluss weitergeführt, und zwar direkt an eine erste Sensoranschlussstelle, im Weiteren als SMD-Anschlußpad bezeichnet. Die zweite Sensoranschlussstelle wird durch den elektrischen Anschluss an die innere Mantelwand 11 des Lochs über die Anschlussfahne 13 in Form einer Leiterbahn hergestellt. Diese Variante hat den Nachteil, dass das Loch, in dem sich die Kugel befindet, nicht hermetisch verschlossen ist. Durch das Sackloch kann Schmutz und Feuchtigkeit in die Kammer gelangen und die Schaltfunktion beeinträchtigen.

### Zweite Variante:

Auf der anderen Seite der Außenplatte wird der elektrische Anschluss zu einer zum Sackloch versetzt befindlichen elektrischen leitfähigen Bohrung, Durchkontaktierung, in einer weiteren Platte weitergeführt, die unter Druck und Hitze an die Bodenplatte geklebt wurde und somit das Sackloch verschließt. Dieses zweite Loch endet zweckmäßigerweise direkt in der ersten SMD-Anschlußfläche. Die zweite SMD-Anschlußfläche ist wie in der Variante 1 ebenfalls durch eine Durchkontaktierung und eine Leiterbahn ausgeführt.

Durch einfache Vervielfältigung ist es problemlos möglich, über 1000 Schalter auf einem 10 cm² großen Substrat unterzubringen. Alternativ zur Leiterplattentechnik besteht dieser Aufbau aus einem Laminat galvanisierter Spritzgussteile.

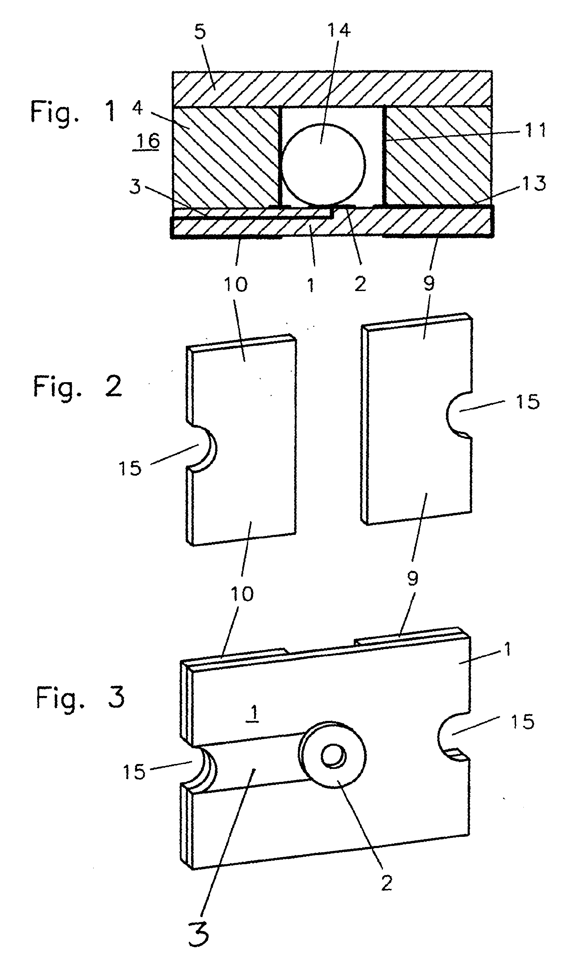

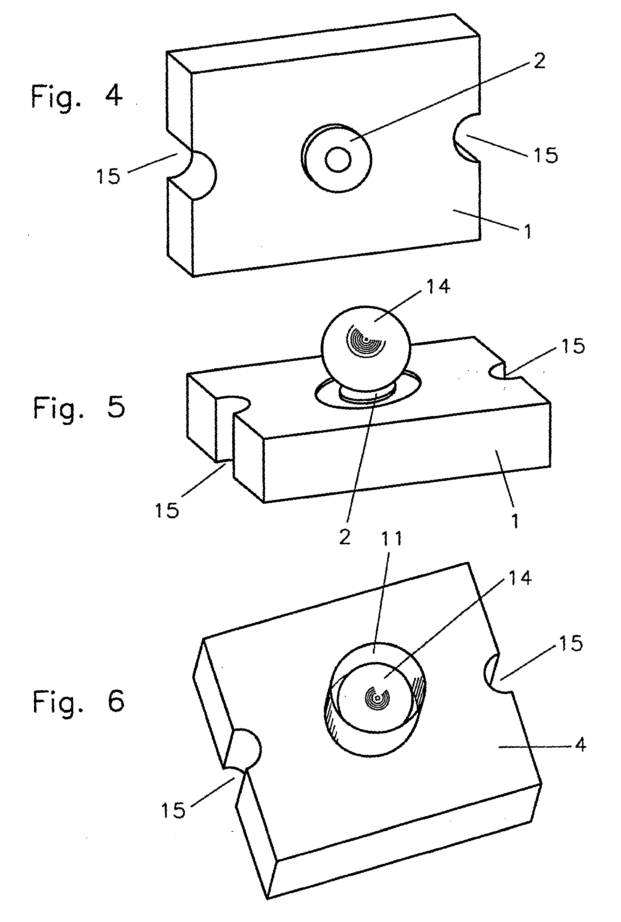

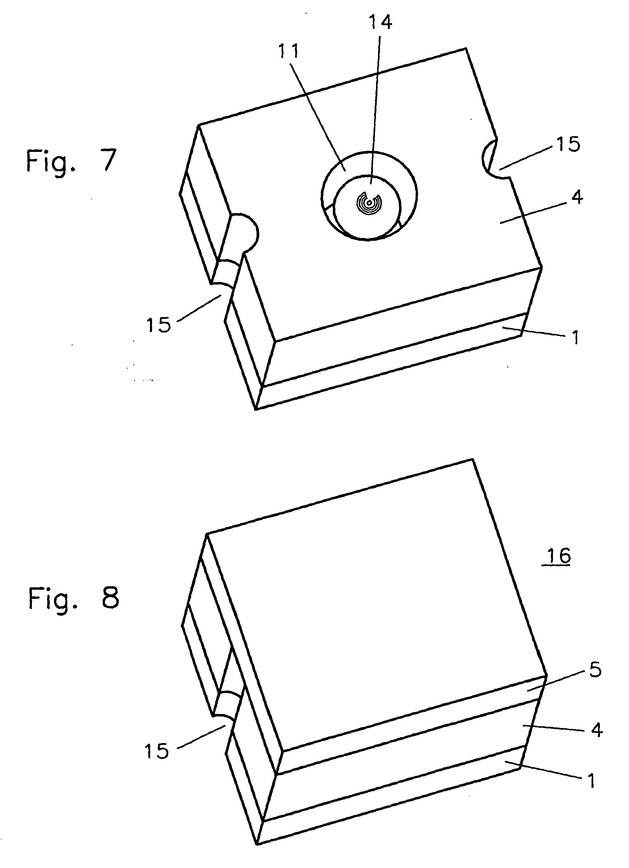

Figur 1 zeigt den Schnitt durch den einzelnen Kugelschalter 14, Figuren 2 bis 8 den sukzessiven schichtartigen Aufbau bis zum hermetisch verschlossenen Schalterloch wie in Figur 8. Die erste Außenplatte 1 des Kugelschalters 16 oder von der Bildorientierung her auch Bodenplatte 1 ist in ihrem schichtartig Aufbau in der Figur 4 im fertigen Zustand dargestellt. Dabei wird von der Boden-Kontaktfläche in der Ausführung für die SMD-Lötung ausgegangen (Figur 2). Figur 3 zeigt die Umkontaktierungsebene zum Anschluss des Mittenkontaktes an die eine, im Bild linke SMD-Kontaktfläche (Rechteckseite). Schließlich wird diese Fläche bis auf die zentrale Ringfläche 2, die eine der mindestens zwei Kontaktflächen, dielektrisch abgedeckt (Figur 4). In Figur 5 ruht die Kugel 14 auf dieser zentralen Ringfläche 2.

Die zweite Kontaktfläche, die zylindrische Mantelwand 11 oder der Becherkontakt, wird durch die weitere Platte, die Lochplatte 4, auf die fertige Außen-/Bodenplatte 1 aufgelegt (Figur 6). Die Anschlussfahne 13 von der inneren zylindrischen Mantelwand 11 führt zur entgegengesetzten Rechteckseite zu dem linken SMD-Pad. Die Kugel 14 hat in Figur 6 eine Lage, bei der sie die Ringfläche 2 am Boden und die Innenwand 11 gleichzeitig berührt. Aus dem Schnitt von Figur 1 gehen die Dimensionen hervor: die Kugel 14 kann sich bewegen, sie ist kleiner als die Zylinderhöhe, eine weitere Kugel hätte in dem Zylindervolumen keinen Platz. In Figur 8 schließlich ist die Kugelschalterkammer hermetisch mit Leiterplattenmaterial verschlossen.

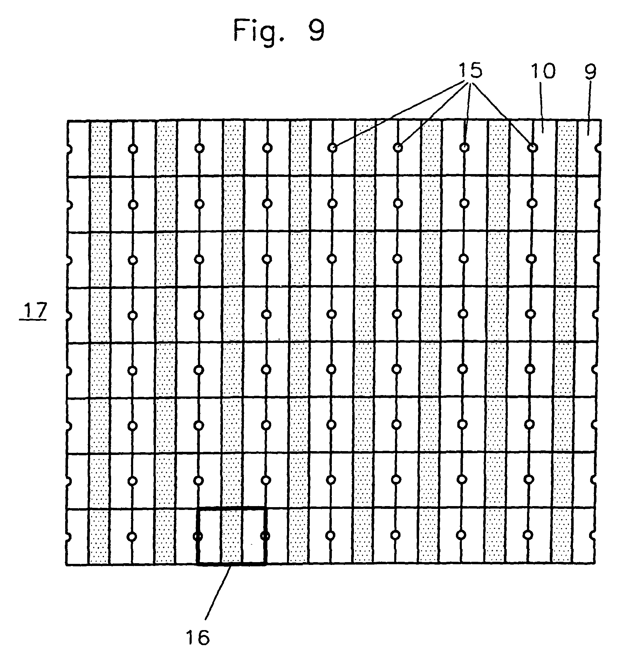

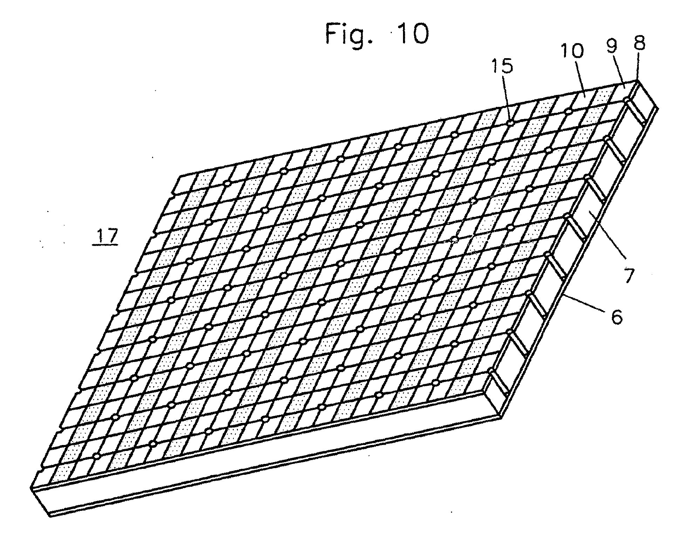

Nach der Herstellung liegen so beispielsweise 1 000 Schalter, in einer Matrix angeordnet vor (Figuren 9 und 10). Die zylindrischen Schalterkammern werden an die Bodenplatte 6 (Deckel) mit den Sacklöchern mit einem elektrisch nicht leitenden Kleber verbunden. In die Löcher oder Becher werden durch Schüttung oder Rakeln die Kugeln 14 eingebracht. Die Höhe des Bechers sollte das 1,3-fache des Durchmessers der Kugel 14 nicht überschreiten. Eine zweite Kugel in dem Schalterloch steht über und wird durch Abziehen mit einem Rakelgummi entfernt, so dass nur eine Kugel 14 in einem Loch/Becher verbleibt.

In der Multi-Kugelschalteranordnung 17 kann die Schalterfunktion aller Schalter gleichzeitig getestet werden.

In Figur 9 teilen sich jeweils zwei Kugelschalter 14 eine Durchkontaktierung und reduzieren damit die Anzahl der Bohrungen 15. Das wird erreicht, wenn bei der Vervielfältigung eine Anordnung der Kugelschalterreihen so gemacht wird, dass die Bohrung 15, die an die Mantelwand 11 respektive an die Ringfläche 2 angeschlossen ist, jeweils für zwei Schalter gleichzeitig verwendet werden und die Kugelschalter 14 mit den SMD-Anschlussflächen 9, 10 dicht nebeneinander liegen, hier beispielsweise ca. 150 µm. Bei der späteren Vereinzelung, etwa durch Sägen, Laser-Schneiden oder Stanzen, werden so mit nur einem Trennvorgang zwei Kugelschalter 14 voneinander getrennt.

In Figur 10 wird der Leiterplattenverbund nicht in einzelne Kugelschalter 14 aufgetrennt. Diese Multi-Kugelschalter-Anordnung 17 wird als Vibrationsschalter verwendet.

### Bezugszeichenliste:

- 1.: erste Platte, Grundplatte
- 2.: Ringscheibe
- 3.: Kontaktfahne
- 4.: zweite Platte, Lochplatte
- 5.: dritte Platte, Deckplatte
- 6.: erste große Platte
- 7.: zweite große Platte
- 8.: dritte große Platte
- 9.: Kontaktfläche
- 10.: Kontaktfläche
- 11.: Mantelwand

- 13.: Kontaktfahne
- 14.: Kugel
- 15.: Bohrung
- 16.: Kugelschalter
- 17.: Multi-Kugelschalter-Anordnung

## Patentansprüche

1. Multi-Kugelschalter-Anordnung in SMD-Technik,
wobei jeder Kugelschalter in Schicht-/Plattenbauweise aufgebaut ist, und zwar:
aus einer ersten Platte (1), der Grundplatte,
einer zweiten Platte (4), der Lochplatte, und
einer dritten Platte (5), der Deckplatte,
die, zusammengebaut, einen kreiszylindrischen, hermetisch abgeschlossenen Hohlraum bilden, in dem sich eine darin bewegliche Kugel aus elektrisch leitendem Material kleineren Durchmessers und kleinerer Länge als der des Hohlraums befindet,
die eine zentrale, elektrisch leitende Ringfläche kleineren Durchmessers als der des Hohlraums am Boden und/oder der Decke des Hohlraums mit der elektrisch leitenden inneren Mantelwand des Hohlraums bei je nach Lage gleichzeitiger Berührung der Mantelwand und einer Ringfläche elektrisch überbrücken kann,
wobei eine Kontaktfahne (3) von einer Kreis(-ring)fläche (2) zwischen ihrer Platte (1) oder (5) und der Lochplatte (4) sowie eine Kontaktfahne (3) von der Mantelwand zwischen der Lochplatte (4) und einer mit einer Ringfläche (2) besetzten Platte nach außen führen,
und wobei die äußere Kontur eines Kugelschalters rechteckig ist,
**dadurch gekennzeichnet, daß** die Kontaktfahne (13) von der Mantelwand (11) in einer äußeren, ersten Kontaktfläche (9) auf der Platte (1) mit Ringfläche (2) entlang einer Kante endet und
die Kontaktfahne (3) von der Ringfläche (2) auf einer äußeren zweiten Kontaktfläche (10) entlang der gegenüberliegenden Kante auf derselben Plattenseite endet,
die Multi-Kugelschalter-Anordnung (17) aus geradlinig aneinandergereihten Reihen solcher Kugelschalter (16) besteht und pro Reihe die Kugelschalter (16) hinsichtlich der Kontaktfahnen (3, 13) gleichartig ausgerichtet sind, so dass die erste, zweite und dritte Platte (1, 4, 5) der Kugelschalter (16) sich jeweils zu einer großen Platte (6), (7) und (8) zusammensetzen/ergänzen und keine der Kontaktfahnen (3, 13) der zweiten großen Platte (7) einen unmittelbaren elektrischen Kontakt zu einer der Kontaktfahnen (3, 13) der ersten großen Platte (6) hat,
die Reihen an Kugelschaltern (16) hinsichtlich ihrer Kontaktfahnen (3, 13) einheitlich ausgerichtet oder zwei unmittelbar benachbarte Reihen von Kugelschaltern (16) hinsichtlich ihrer Kontaktfahnen (3, 13) spiegelbildlich zueinander angeordnet sind.

2. Multi-Kugelschalter-Anordnung (17) nach Anspruch 1,
**dadurch gekennzeichnet,**
**dass** die beiden Außenplatten (6) und (8) und die Lochplatte (7) aus handelsüblichen, mit den notwendigen elektrischen Leiterstrukturen versehenen Leiterplatten sind, wobei die Lochplatte(7) an den Plätzen der Kugelschalter (16) einfach durchbohrt ist.

## Claims

1. Multiple ball-switch arrangement in SMD technology, each ball switch being constructed in a layer/plate type of construction, that is to say it comprises:
a first plate (1), the bottom plate,
a second plate (4), the perforated plate, and
a third plate (5), the top plate,
which, when assembled, form a circular-cylindrical, hermetically sealed hollow chamber, in which is situated a ball, which is displaceable therein and is formed from electrically conductive material with a smaller diameter and shorter length than the dimensions of the hollow chamber,
which ball can bridge electrically a central, electrically conductive annular face, having a smaller diameter than that of the hollow chamber at the base and/or that of the top of the hollow chamber, with the electrically conductive internal casing wall of the hollow chamber when, according to their positions, the casing wall and an annular face are simultaneously in contact with each other,
a contact lug (3) extending outwardly from a circular (annular) face (2) between its plate (1) or (5) and the perforated plate (4), and a contact lug (3) extending outwardly from the casing wall between the perforated plate (4) and a plate which is provided with an annular face (2),
and the outer configuration of a ball switch being rectangular,
**characterised in that** the contact lug (13) of the casing wall (11) terminates in an external, first contact face (9) on the plate (1) with annular face (2) along one edge, and
the contact lug (3) of the annular face (2) terminates on an external, second contact face (10) along the oppositely situated edge on the same plate side,
the multiple ball-switch arrangement (17) comprises such ball switches (16) arranged in rectilinearly adjacent rows, and per row the ball switches (16) are identically orientated with regard to the contact lugs (3, 13), so that the first, second and third plates (1, 4, 5) of the ball switches (16) are combined/integrated to form a large plate (6), (7) and (8) respectively, and
none of the contact lugs (3, 13) of the second large plate (7) has a direct electrical contact with one of the contact lugs (3, 13) of the first large plate (6), and
the rows of ball switches (16) are uniformly orientated with regard to their contact lugs (3, 13), or two directly adjacent rows of ball switches (16) are disposed with regard to their contact lugs (3, 13) in a mirror-inverted manner relative to each other.

2. Multiple ball-switch arrangement (17) according to claim 1, **characterised in that** the two external plates (6) and (8) and the perforated plate (7) are formed from commercially available printed circuit boards provided with the necessary electrical conductor structures, the perforated plate (7) being simply bored at the locations of the ball switches (16).

## Revendications

1. Montage à multiples commutateurs à bille en technique SMD selon laquelle chaque commutateur à bille est réalisé selon une construction en couches ou en plaques et cela :
avec une première plaque 1 qui est la plaque de base, une seconde plaque 4 qui est la plaque à trou et une troisième plaque 5 qui est la plaque de couverture, ces plaques étant assemblées pour former une cavité cylindrique circulaire hermétiquement fermée dans laquelle peut se déplacer une bille mobile en matière électro-conductrice, de plus petit diamètre et de longueur plus faible que la cavité,
la bille pouvant ponter électriquement une surface annulaire centrale électro-conductrice ayant un diamètre plus petit que celui de la cavité au fond et/ou de la couverture de la cavité, avec une enveloppe intérieure électro-conductrice de la cavité, quand chaque fois suivant sa position elle touche en même temps la paroi enveloppe et une surface annulaire,
avec une patte de contact 3 partant d'une surface circulaire (annulaire) 2 entre sa plaque 1 ou 5 et la plaque de circuit 4, ainsi qu'une patte de contact 3 partant de la paroi enveloppe entre la plaque de circuit 4 et une plaque munie d'une surface annulaire 2, le deux pattes conduisant vers l'extérieur, et
le contour extérieur d'un commutateur à bille étant rectangulaire,
**caractérisé en ce que**
la patte de contact 13 passe de la paroi enveloppe 11 en se terminant le long d'une arête dans une première surface de contact 9 extérieure sur la plaque 1 ayant une surface annulaire 2, et la patte de contact 3 de la surface annulaire 2 se termine sur une seconde surface de contact extérieure 10 le long de l'arête opposée du même côté de plaque,
le montage à multiples commutateurs à bille 17 étant formé d'une disposition en ligne droite, juxtaposés de tels commutateurs à bille 16 et pour chaque rangée, le commutateur à bille 16 est aligné de la même manière pour les pattes de contact 3, 13 de façon que la première, la seconde et la troisième plaque 1, 4, 5 des commutateurs à bille 16 s'assemblent ou se complètent en une plaque de grande dimension 6, 7, 8, et aucune des pattes de contact 3, 13 de la seconde grande plaque 7 n'est en contact électrique direct avec l'une des pattes de contact 3, 13 de la première grande plaque 6,
les rangées de commutateurs à bille 16 étant alignés de manière uniforme pour leur patte de contact 3, 13, ou deux rangées directement voisines de commutateurs à billes 16 sont disposées selon une symétrie plane l'une par rapport à l'autre du point de vue de leur patte de contact 3, 13.

2. Montage à multiples commutateurs à billes 17 selon la revendication 1,
**caractérisé en ce que**
les deux plaques extérieures 6 et 8 et la plaque à trou 7 sont des plaques de circuit du commerce ayant les structures conductrices électriques requises, la plaque à trou 7 étant simplement percée à l'emplacement des commutateurs à bille 16.
